# EUROPEAN PATENT APPLICATION

(11) **EP 1 526 158 A1**
(43) Date of publication of application: **27.04.2005**
(21) Application number: 04106876.8
(22) Date of filing: 22.12.2004
(51) Int. Cl.: C08L 81/06

(54) **Electronic components**

(71) Applicant: Solvay Advanced Polymers, L.L.C., Alpharetta, GA 30005-3914 (US)
(72) Inventor: Cupta, Glenn W., 30075, Roswell (US); El-Hibri, Mohammad Jamal, 30328, Atlanta (US)
(74) Representative: Jacques, Philippe

(57) **Abstract**

The invention relates to an electronic component components made from a polymer composition comprising at least 70 weight % of at least one high glass transition sulfone polymer, to a method of manufacturing said electronic component and to an electronic assembly comprising said component Electronic components, especially substrates, made from this polymer composition exhibit high HDT, low moisture pick-up, and isotropic strength and toughness properties necessary to survive the high temperature lead-free soldering operations used in circuit board and flex circuit assembly techniques.

## Description

### TECHNICAL FIELD

This invention is directed to an electronic component made from polymer compositions, to a method of manufacturing said electronic component and to an electronic assembly comprising said component.

### BACKGROUND OF THE INVENTION

Electronic components, especially electronic substrates, are exposed to high temperatures during processing to prepare electronic devices such as semiconductor chips, connectors, capacitors, light emitting diodes (LEDs), relays, sensors, coils and switches. Among the high temperature processes that electronic components are exposed to are mounting or assembling the electronic active element on an electronic component, for instance on a substrate such as a printed circuit board (PCB) or a flex circuit. Electronic active elements are typically mounted on substrates by soldering. Electronic active elements and electronic components, especially electronic substrates, need to be made of materials that are able to survive the temperatures experienced during the soldering operation. These temperatures can reach as high as 260 °C for short periods of time.

Methods of mounting electronic active elements on an electronic component include the traditional through hole mounting, wherein the active elements are positioned on a front side of a substrate and leads from the active elements are inserted in through holes into the substrate. The active elements are subsequently affixed to the substrate by exposing the back surface of the substrate to a solder wave.

Increased electronic density can be achieved through the use of Surface Mount Technology (SMT). In SMT, the electronic active elements are mounted on a solder footprint formed on the surface of the substrate. SMT was developed to allow for the optimum usage of the space available on a PCB. Infrared (IR) reflow is the most commonly used method to bond (solder) surface mount electronic active elements to the substrate.

Conventionally, tin-lead solders were used to attach electronic active elements to electronic components, especially substrates. Recently, the use of lead in solder has come under scrutiny because of the known safety issues concerning the use of lead. Consequently, the use of lead-free solders, such as copper-silver, copper-tin, and nickel-silver solders, have become increasingly popular. Lead-free solders, however, generally have higher melting points than tin-lead solders. Therefore, the use of lead free solders requires higher processing temperatures than lead solders. As a result, the electronic components, such as for instance substrates, are exposed to higher temperatures.

Because of their high mechanical properties and high heat deflection temperatures (HDT), typically semi-crystalline polymeric thermoplastic materials such as poly(phenylene sulfide) (PPS), the polyester from cyclohexane dimethanol and ethylene glycol (PCT) and nylon 4, 6 have been conventionally used for electronic component applications. However these materials can blister or crack during the solder operation because of moisture absorption (in the case of nylons), low elongation and lack (or loss) of mechanical properties at soldering temperatures. They may also suffer from other problems such as a tendency to warp due to the fibrous reinforcements that typically have to be present in these systems, coupled with the relatively large shrinkage factors associated with the injection molding of semi-crystalline resins. Less than optimal molding of these materials can also result in incomplete crystallization during the molding process which can cause dimensional changes, shrinkage and warpage in assembled parts due to subsequent crystallization when these parts or components are heated during the solder reflow operation. All these issues are generically referred to as dimensional stability issues. The presence of fibrous reinforcement in the semicrystalline resins alluded to above also cause anisotropic mechanical behavior where the material exhibits higher strength and elongation properties in the direction of the reinforcement than in the direction normal to the reinforcement such as along injection molding weld lines. This directional brittleness and also anisotropic thermal expansion associated with glass fiber filled products can lead to poor pin retention.

Conventionally, epoxy-fiberglass compositions and high temperature polyimide have been used to form electronic component, especially substrates, such as printed circuit boards and flex circuits. However, at the higher temperature required for lead-free solder processing epoxy fiberglass printed circuit boards do not have adequate dimensional stability and polyimides suffer from moisture pickup. The exposure to high soldering temperatures and/or moisture pickup can result in a lack of dimensional stability, such as warping, of the electronic substrates. In addition, epoxy-fiberglass is a thermoset composition, limiting its application in forming extruded and injection molded components. Commercially available polyimides which are used for electronic component substrates similarly lack thermoplastic processing attributes and are supplied as fmished films which are produced by an elaborate reactive casting process. So there is little flexibility in the shapes or thicknesses of polyimide substrates that can be used.

Furthermore, flame retardance is a requirement of many electronic components and in particular of electronic substrates. Many polymeric materials used for forming electronic components are not flame retardant. Therefore, frequently a flame retardant additive, usually a brominated aromatic hydrocarbon or brominated polystyrene needs to be incorporated into the resin composition to effect sufficient resistance to burning commensurate with the needs of electrical/electronic uses. These brominated flame retardants have a number of drawbacks including : corrosivity toward processing equipment due to the generation of HBr gas at melt processing temperatures, the substantial toxic smoke emission associated with their combustion behavior, and the questionable ecological impact of these types of materials in regards to their safety in disposal or incineration.

In addition, most high-temperature polymer compositions used in the electronic components art today are opaque, thus limiting their use in electronic component applications that require a transparent polymer, such as optoelectronic components.

### SUMMARY OF THE INVENTION

There exists a need in the electronic component art, especially in the electronic substrate art, for components and substrates comprising polymers that have a high glass transition temperature and maintain dimensional stability when processed at lead-free solder soldering temperatures. There exists a need in the electronic component art, especially in the electronic substrate art, for components and substrates that are transparent. There further exists a need in the electronic component art, especially in the electronic substrate art, for halogen free components and substrates that are flame retardant. In addition, there exists a need in the electronic component art, especially in the electronic substrate art, for components and substrates that are formed by extrusion or injection moulding.

These and other needs are met by an electronic component comprising a polymer composition comprising at least 70 % wt of at least one high glass transition temperature sulfone polymer [polymer (A)].

The electronic component comprise advantageously at least 80 % wt, preferably at least 90% wt, more preferably at least 95% wt of polymer composition, with respect to the total weight of the electronic component.

For the purpose of the invention, the term "polymer" is intended to denote any material consisting essentially of recurring units, and having a molecular weight above 2000.

The term "high glass transition temperature sulfone polymer" [polymer (A)] is intended to denote any polymer, at least 50 % wt of the recurring units thereof being recurring units (R1): 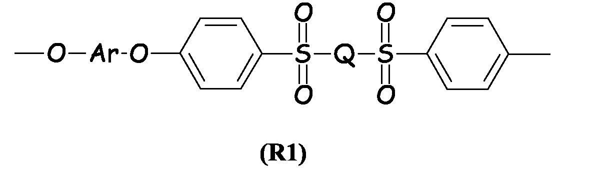 wherein :
- **Q** is a group chosen among the following structures : 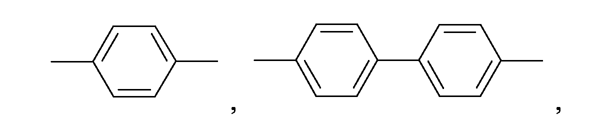 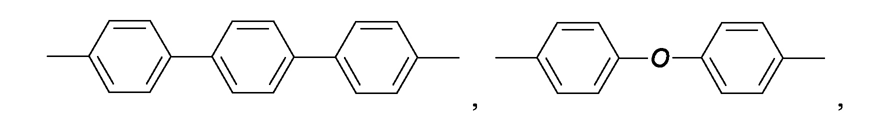 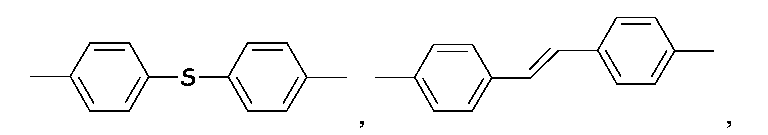 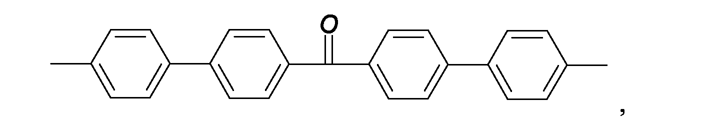 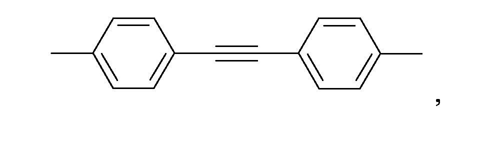 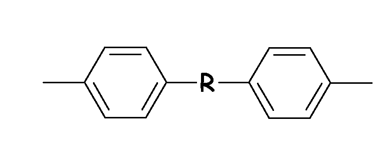 with **R** being : 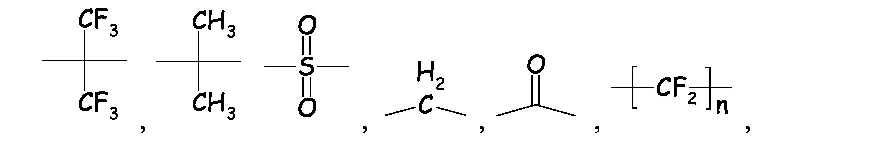 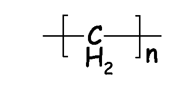 with n = integer from 1 to 6, or an aliphatic divalent group, linear or branched, of up to 6 carbon atoms;
   and mixtures thereof; and
- **Ar** is a group chosen among the following structures : 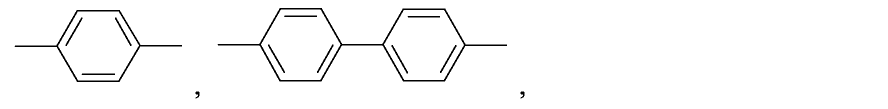 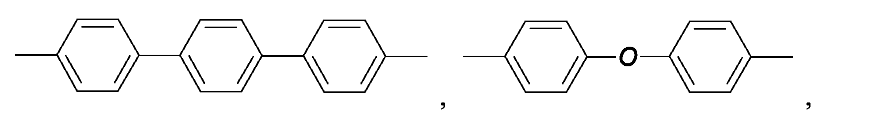 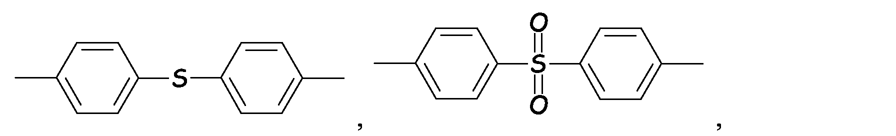 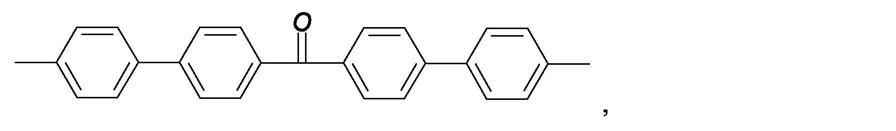 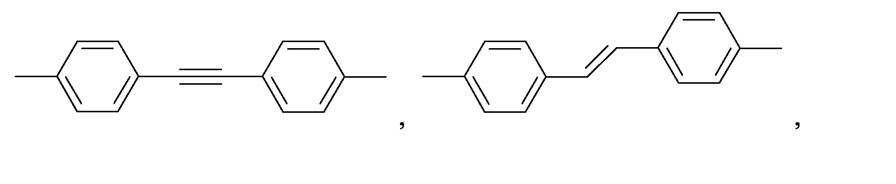 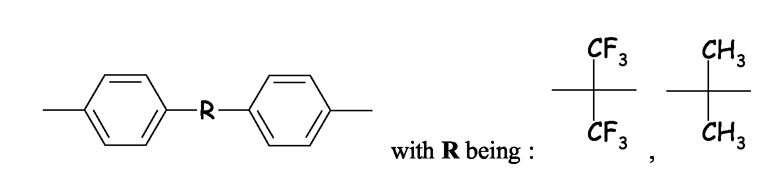 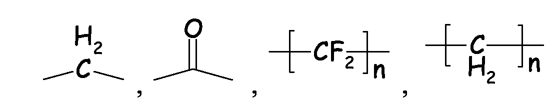 with n = integer from 1 to 6, or an aliphatic divalent group, linear or branched, of up to 6 carbon atoms; and mixtures thereof.

Electronic components according to the invention advantageously exhibit high HDT, low moisture pick-up, and isotropic strength and toughness properties necessary to survive the high temperature lead-free soldering operations used in circuit board and flex circuit assembly techniques. The excellent toughness, hydrolytic stability, and dimensional stability of electronic components according to embodiments of this invention advantageously allows for excellent pin retention. Furthermore, certain electronic components according to the present invention are advantageously flame retardant. In addition, certain electronic components according to the present invention are advantageously substantially transparent and are therefore notably well-suited for applications where transparency is important, such as sensor housings and covers and optoelectronic device components like LEDs.

### DETAILED DESCRIPTION OF THE INVENTION

The present invention provides electronic components comprising a polymer composition comprising at least 70 % wt of at least one high glass transition temperature sulfone polymer [polymer (A)].

As non limitative examples of electronic components, mention may be notably made of electronic substrates such as printed circuit boards (PCB), of electrical plug-in connectors, of mono-block electrical connectors, of retention members for electrical contacts, of integrated circuit test sockets, of high temperature resistant bobbins for relays and solenoids, of trimming potentiometer rotors, sensor housing and covers, of substrates for hole or surface mounting.

The electronic components of the invention advantageously provide improved high-temperature dimensional stability, improved flame retardancy with no need of halogenated additives, and improved transparency.

The present invention advantageously allows the high temperature processing of electronic components, especially substrates, of improved transparency without the attendant decrease in dimensional stability observed in prior art electronic components and substrates. Coupled with all the above benefits, the present invention advantageously allows for the economical thermoplastic fabrication in the manufacturing of said electronic components.

These advantages and benefits are provided by an electronic component comprising a polymer composition comprising at least 70% wt of at least one high glass transition temperature sulfone polymer [polymer (A)]. At least 50 % wt of the recurring units of polymer (A) are recurring units (R1) : 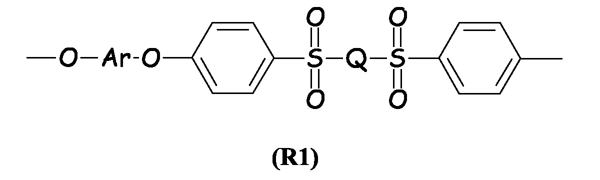 wherein **Ar** and **Q** have the meanings above specified.

Recurring units (R1) are preferably chosen from : 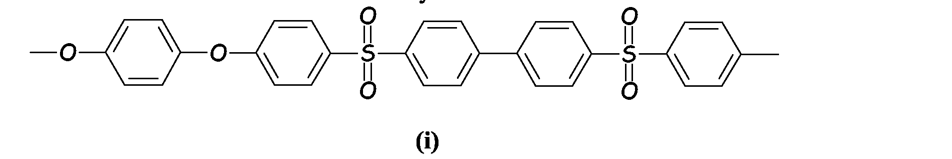 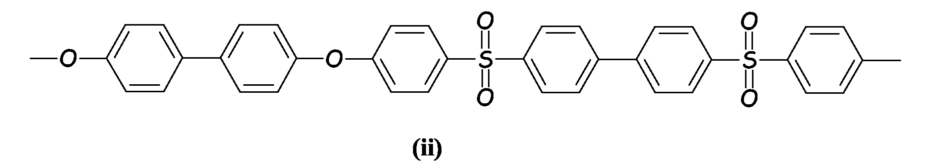 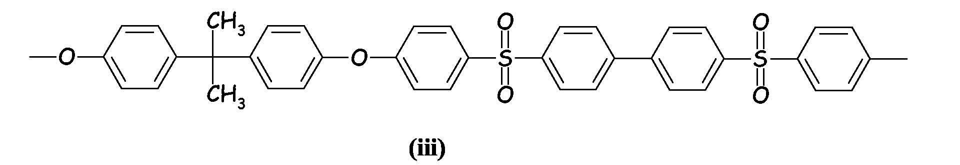 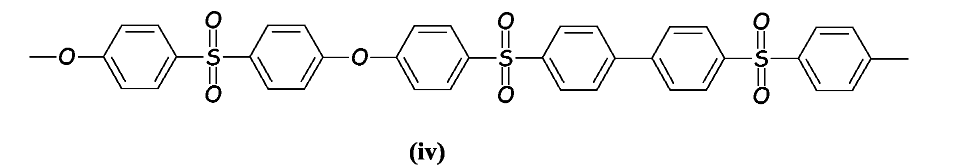 and mixtures therefrom.

More preferably, recurring units (R1) are recurring units (ii).

In a particular embodiment of the invention; the polymer (A) notably further comprises recurring units (R2) : 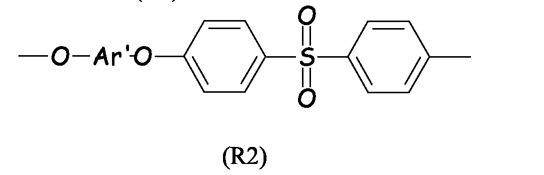 wherein Ar' is chosen among : 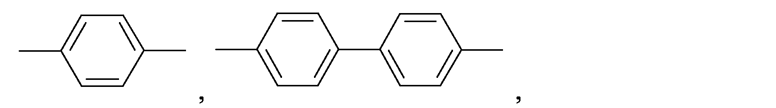 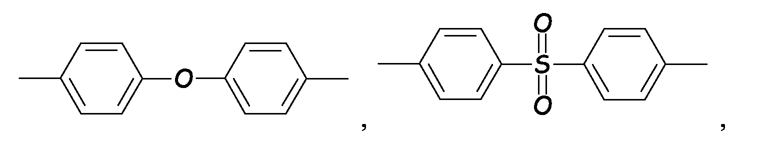 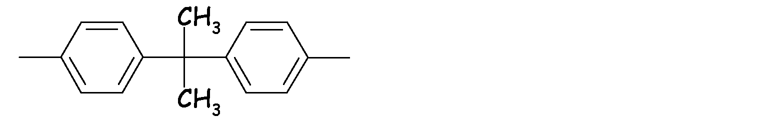 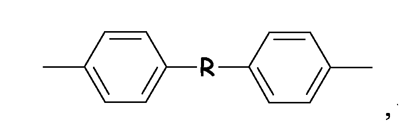 with **R** being an aliphatic divalent group of up to 6 carbon atoms, such as methylene, ethylene, isopropylene and the like [polymer (A*)].

Recurring units (R2) are preferably chosen from : 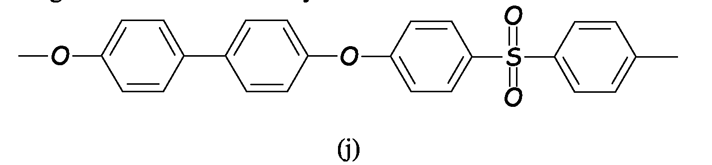 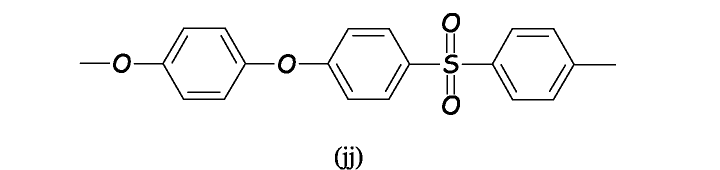 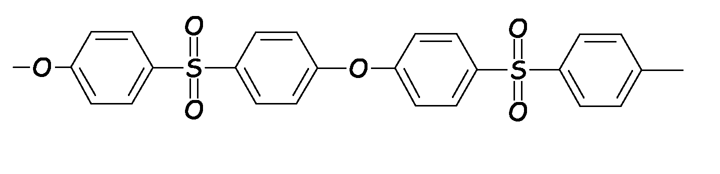 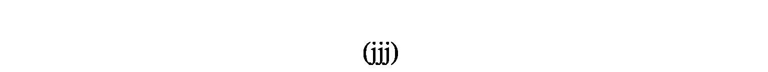 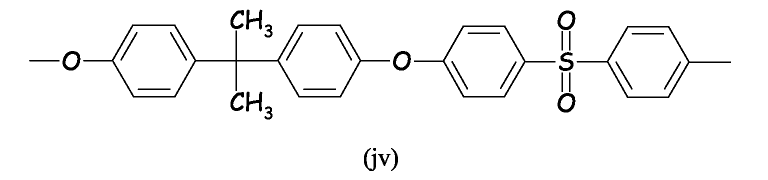 and mixtures thereof

Polymer (A*) may notably be a random, alternating or block copolymer. Preferably, it is a block copolymer.

Polymer (A) comprises preferably 70 % wt, more preferably 75 % wt of recurring units (R1). Still more preferably, it contains no recurring unit other than recurring units (R1).

Excellent results were obtained with polymers (A) the recurring units of which are recurring units (ii).

Polymers (A) the recurring units of which are recurring units (ii) can be advantageously manufactured by the polycondensation reaction between 4,4'-bis[(4-chlorophenylsulfonyl)-1,1'-biphenyl and biphenol.

The polymer composition comprises preferably at least 75% wt, more preferably at least 80 % wt of polymer (A).

Such polymer compositions have advantageously glass transition temperatures in the range of about 240-275 °C and therefore, can be notably used in surface mount applications where temperatures of around 230-260 °C are possible during the solder reflow step.

According to certain embodiments of the present invention, the polymer composition can further comprise at least one polyetherimide and/or at least one sulfone polymer selected from the group consisting of polysulfone, polyethersulfone, polyphenylsulfone, polyetherethersulfone, and copolymers and mixtures thereof.

For the purpose of the invention, the term "polyetherimide" is intended to denote any polymer, at least 50 % wt of the recurring units thereof comprising recurring units (R3), comprising two imide groups as such (R3-A) and/or in their corresponding amic acid forms [(R3-B) and (R3-C)] : 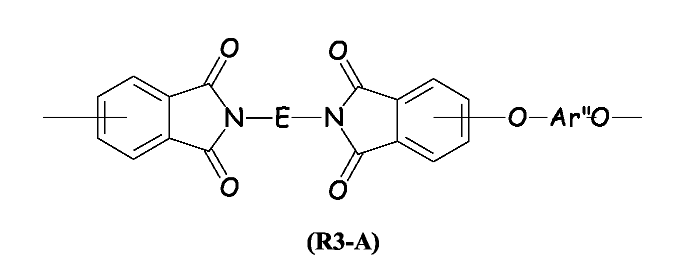 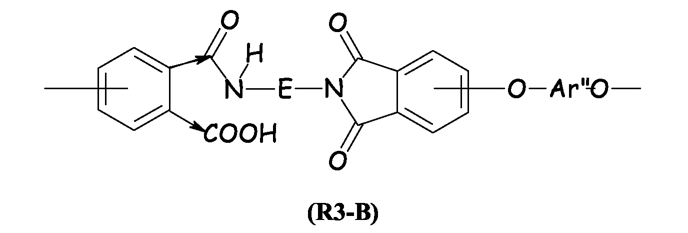 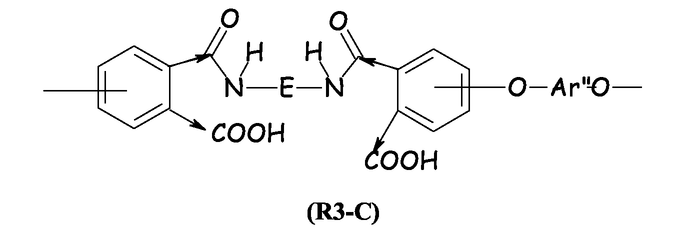 wherein :
- the → denotes isomerism so that in any recurring unit the groups to which the arrows point may exist as shown or in an interchanged position;
- **E** is typically : 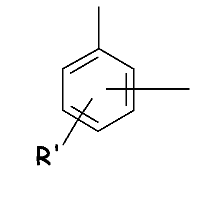 with **R'** being a hydrogen atom or an alkyl radical comprising from 1 to 6 carbon atoms ; 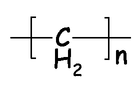 with n = integer from 1 to 6 ; 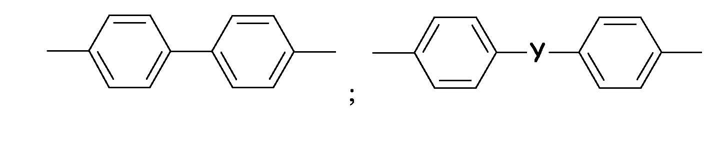 with **Y** being : 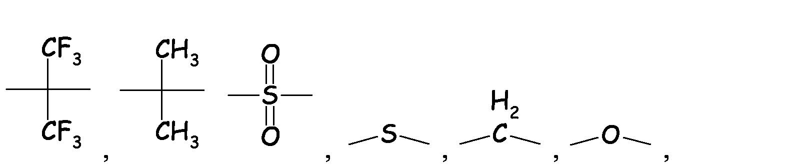 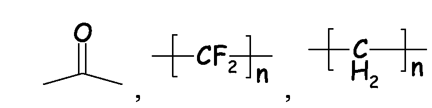 with n = integer from 1 to 6 ;
- **Ar"** is typically : 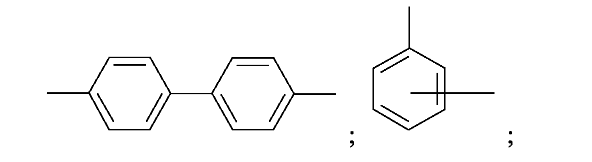 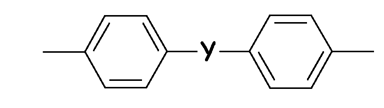 with **Y** being : 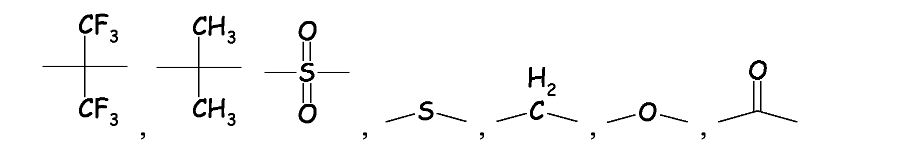 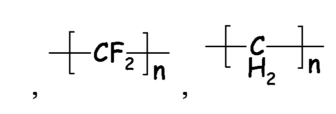 with n = integer from 1 to 6.

Recurring units (R3) are preferably recurring units (k), in imide form (k-A) and/or in amic acid forms [(k-B) and (k-C)] : 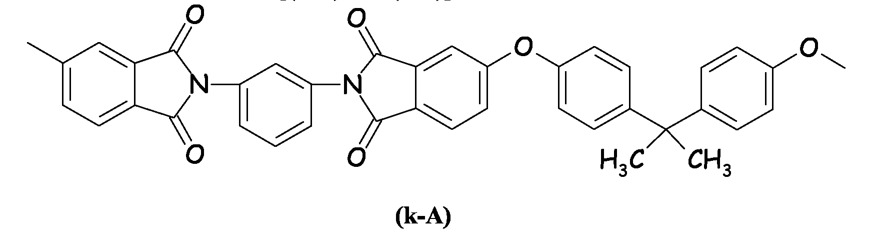 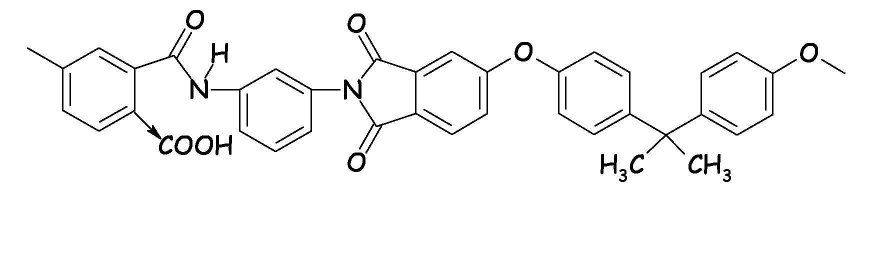 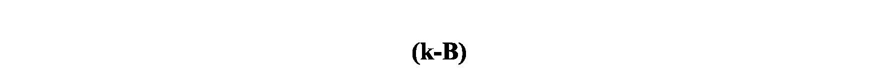 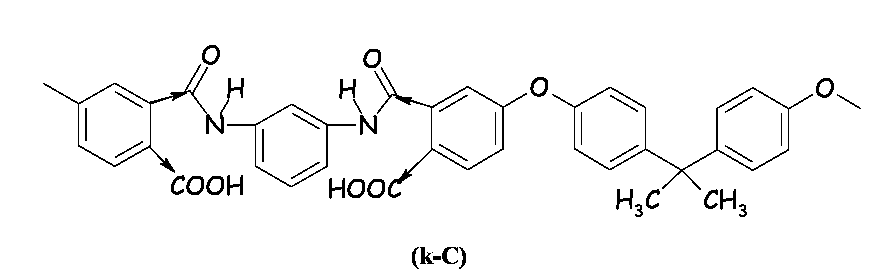 wherein in formulae (k-B) and (k-C) the → denotes isomerism so that in any recurring unit the groups to which the arrows point may exist as shown or in an interchanged position.

For clarity, the structural repeat units of polyphenylsulfone, polysulfone, polyethersulfone, and polyetherethersulfone are listed below : 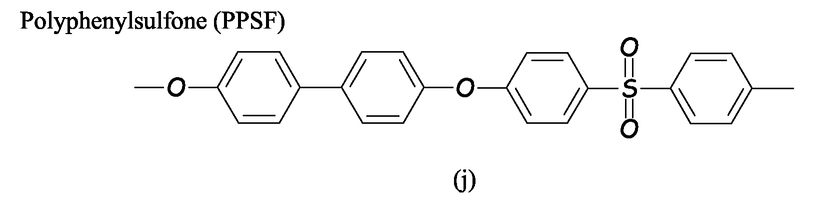 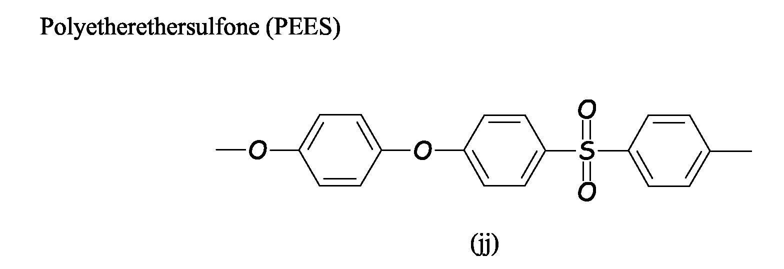 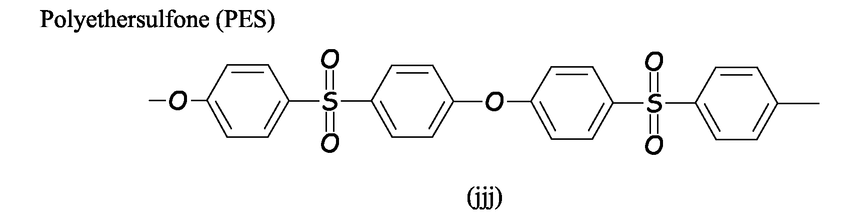 and/or
mixtures of (jj) and (jjj)

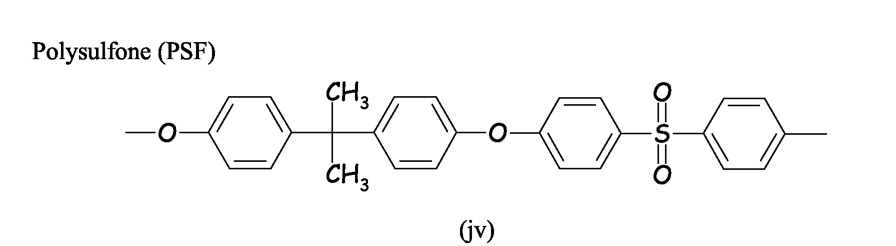

Polyphenylsulfone is available as RADEL® R PPSF from Solvay Advanced Polymers, L.L.C.. Polysulfone is available as UDEL® PSF from Solvay Advanced Polymers, L.L.C.. Polyethersulfone is available as RADEL® A PES from Solvay Advanced Polymers, L.L.C.. Polyetherethersulfone (jj) is the polymer formed from the polycondensation of 4,4'-dihalodiphenylsulfone and hydroquinone.

The polymer composition can further comprise notably at least one filler chosen from reinforcing fillers, structural fibers and mixtures thereof. Structural fibers may include glass fiber, carbon or graphite fibers, and fibers formed of silicon carbide, alumina, titania, boron and the like, and may include mixtures comprising two or more such fibers.

Reinforcing fillers which can also be used in the polymer composition include notably pigments, flake, spherical and fibrous particulate filler reinforcements and nucleating agents such as talc, mica, titanium dioxide, potassium titanate, silica, kaolin, chalk, alumina, mineral fillers, and the like. The reinforcing fillers and structural fibers can be used alone or in any combination.

The polymer composition can also further comprise other ingredients such as stabilizers, i.e., metal oxides such as zinc oxide, antioxidants, flame retardants.

Should the polymer composition comprise at least two ingredients, it is advantageously prepared by any conventional mixing method. A preferred method comprises mixing the polymer (A) and the optional ingredients in powder or granular form in an extruder and extruding the mixture into strands and chopping the strands into pellets. Said pellets are advantageously molded into the desired electronic component.

The polymer composition can be molded into electronic components using conventional techniques.

Specifically, the polymer composition can be molded into circuit board substrates using conventional molding equipment. The molded boards are then swelled and etched to promote the adhesion of copper by both roughening the surface and introducing chemical moieties through oxidation. The circuitry is then applied to the board by either a conventional additive or a semiadditive process. In either case copper is applied to the substrate in an electroless manner after the application of catalysts which activate the surface to the deposition of metal in a conventional manner.

Otherwise, mono-block electrical connectors may be notably manufactured by molding in brass inserts along the length of the entire electronic component body comprising the polymer composition. The whole mono-block article as molded comprising the polymer composition and the brass is then advantageously immersed in a strong acid bath. The acid advantageously completely dissolves the brass, without affecting the electronic component and leaves the perfectly formed required undercuts in the body of the electronic component.

Integrated circuit test sockets are advantageously manufactured by injection molding the polymer composition, on conventional molding equipment using multicavities and cycle times from 10 to 50 seconds.

Another aspect of the present invention concerns an electronic assembly comprising :
(i) at least one electronic component, especially substrate, as above described, and
(ii) at least one electronic active element mounted on the electronic component.

In certain embodiments of the present invention, the electronic active element mounted on the electronic component or substrate can be a through hole mounted element or a surface mounted element.

Still another aspect of the present invention concerns a method of manufacturing an electronic component as above described.

Advantageously, the method comprises molding a polymer composition comprising at least 70% wt of polymer (A).

This invention will be described in conjunction with electronic components and substrates made from specific examples of compositions. However, these are exemplary only, as the claimed invention is not limited to the specific examples of electronic components described herein.

### Example

A polymer composition consisting of a high glass temperature sulfone polymer obtained by the polycondensation reaction between 4,4'-bis[(4-chlorophenylsulfonyl)-1,1'-biphenyl and biphenol is used.

Molded articles are injection molded on a Battenfeld injection molding machine with a 3 oz. injection capacity.

### Plating of the molded article

Plating of the thus obtained molded articles is effected by the following process, comprising a first step of electroless plating (a) and a further step of electroplating (b).

### a) ELECTROLESS PLATING

The injection molded article is annealed in an oven with internal air circulation at a temperature ranging from 150 to 220 °C for 3-5 hours. It is then degreased by immersion in a hot detergent solution in water (kept at 65 °C) and rinsed with water.

The article as molded is then etched by immersion in a bath of 400 g/l of chromic anhydride and 220 ml/l of concentrated sulfuric acid at 50-90°C for 10-60 minutes, and again rinsed with water and neutralized. The article is then dipped in a 150 ml/l solution of concentrated hydrochloric acid at a room temperature for 2 minutes and contacted with a suitable plating catalyst and accelerator.

The article is finally dipped in a suitable electroless plating Copper solution at a room temperature to form a 0.3-0.5 µm thick copper film.

### b) ELECTROPLATING

Using the electroless-plated article, obtained as above described as cathode and phosphorus copper as anode, placed in a 200 g/l solution of copper sulfate, an electric current is passed therebetween at a current density of 3 A/dm² to form a 50 µm thick metallic deposit on the article.

### Preparation of a printed circuit board

For forming the conductive circuits on the molded article (the board, hereinafter), the semi-additive method is applied. The composition is molded into a desired configuration by injection molding as above detailed, and the whole surface on which electric circuits are to be formed is subjected to electroless copper plating to form an approximately 0.3-0.5 µm thick copper deposit, as above detailed. Then the negative image of a desired circuit pattern is printed thereon with a resist ink, followed by electro-plating on the whole surface (saving the resist ink printed portion) to form an approximately 50 µm thick copper deposit. Next, the resist ink is removed by a resist ink stripping liquid, and finally the copper film formed by electroless plating on the underside of the resist ink printed portion is eliminated by the action of the etching solution to thereby form the desired circuit on the printed circuit board. In this case, the board material is required to have a quality enabling formation of the circuit with a fine line width. Such a requirement is met by the board obtained from the polymer composition comprising the high glass transition temperature sulfone polymer : such board has excellent mechanical properties, thermal properties (in terms of heat distortion temperature and linear thermal expansion coefficient), dimensional stability and thermal stability during processing as well as good surface smoothness.

The embodiments illustrated in the instant disclosure are for illustrative purposes. They should not be construed to limit the scope of the claims. As is clear to one of ordinary skill in this art, the instant disclosure encompasses a wide variety of embodiments not specifically illustrated herein.

## Claims

1. Electronic component comprising a polymer composition comprising at least 70 % wt of at least one high glass transition temperature sulfone polymer [polymer (A)], namely a polymer at least 50 % wt of the recurring units thereof are recurring units (R1) : 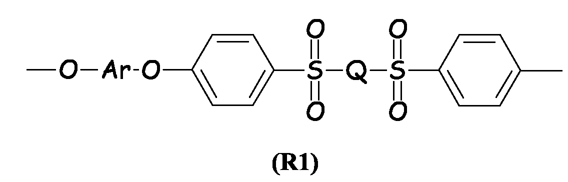 wherein :
- **Q** is a group chosen among the following structures : 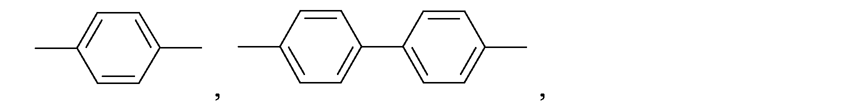 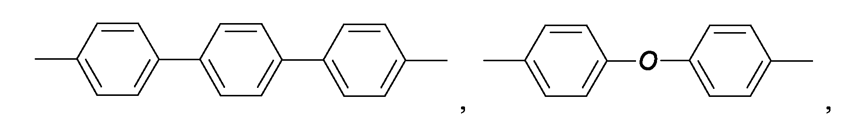 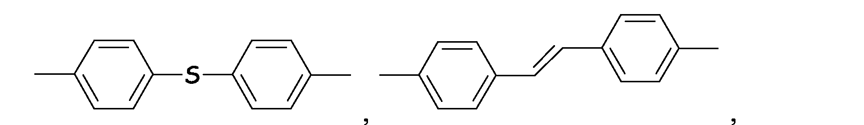 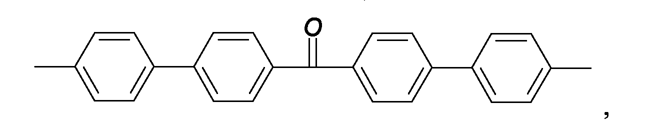 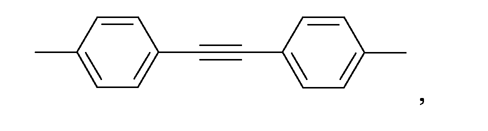 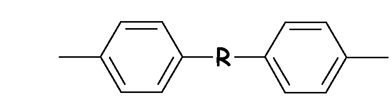 with **R** being : 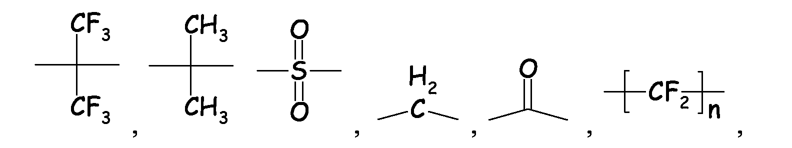 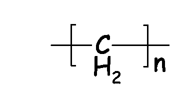 with n = integer from 1 to 6, or an aliphatic divalent group, linear or branched, of up to 6 carbon atoms;
and mixtures thereof; and
- **Ar** is a group chosen among the following structures : 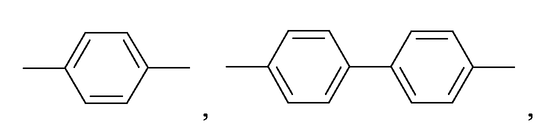 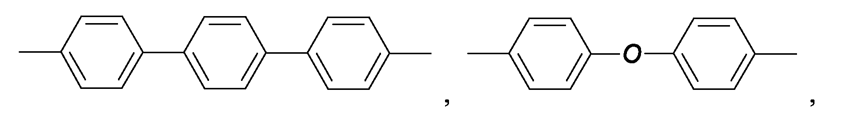 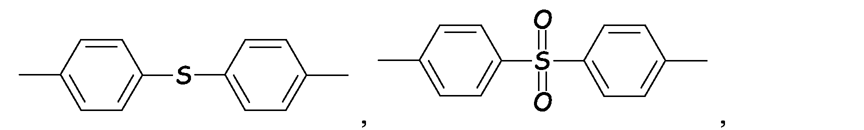 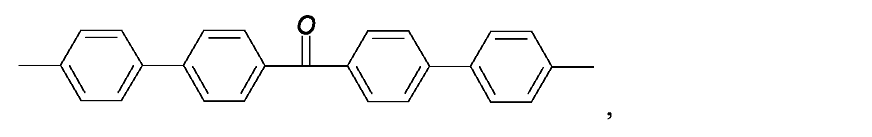 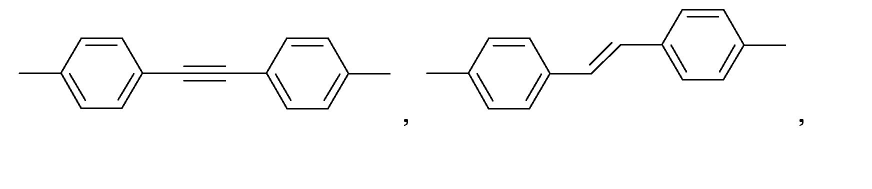 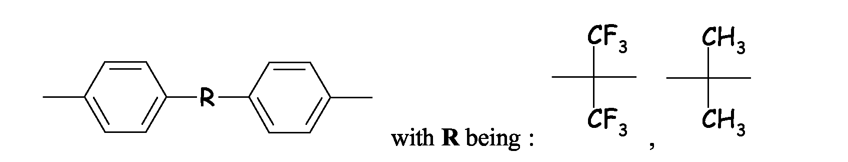 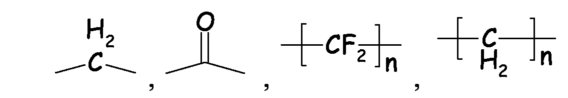 with n = integer from 1 to 6, or an aliphatic divalent group, linear or branched, of up to 6 carbon atoms;
and mixtures thereof.

2. Electronic component of Claim 1, **characterized in that** recurring units (R1) are preferably chosen from: 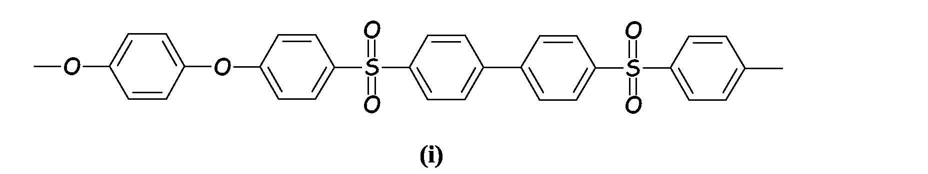 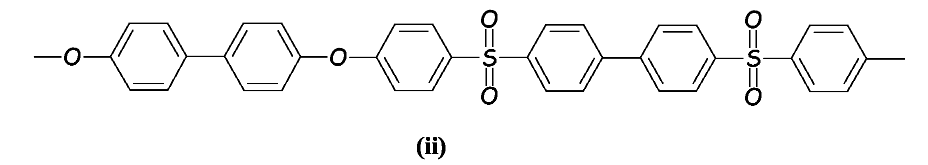 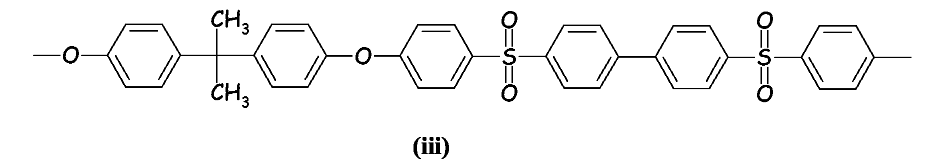 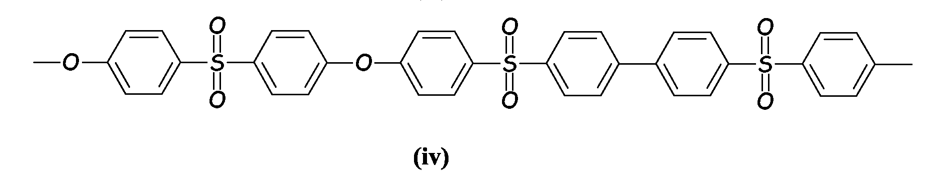 and mixtures therefrom.

3. Electronic component of Claim 1 or 2, **characterized in that** polymer (A) contains no recurring unit other than recurring units (R1).

4. Electronic component of anyone of Claims 1 to 3, **characterized in that** the polymer composition comprises at least one polyetherimide and/or at least one sulfone polymer selected from the group consisting of polysulfone, polyethersulfone, polyphenylsulfone, polyetherethersulfone, and copolymers and mixtures thereof.

5. Electronic component of anyone of Claims 1 to 4, **characterized in that** the polymer composition comprises at least one filler chosen from reinforcing fillers, structural fibers and mixtures thereof.

6. Electronic assembly comprising :
- at least one electronic component according to any of the preceding Claims, and
- at least one electronic active element mounted on the electronic component.

7. The electronic assembly of Claim 6, **characterized in that** the electronic active element mounted on the electronic component is a through hole mounted element.

8. The electronic assembly of Claim 6, **characterized in that** the electronic component is a surface mounted element.

9. A method of manufacturing an electronic component according to anyone of Claims 1 to 5.

10. The method according to Claim 9, wherein it comprises molding a polymer composition comprising at least 70% wt of polymer (A).
